(19) Europäisches Patentamt
European Patent Office
Office européen des brevets

(11) EP 1 727 847 B1

(12) # EUROPÄISCHE PATENTSCHRIFT

(45) Veröffentlichungstag und Bekanntmachung des Hinweises auf die Patenterteilung:
**06.10.2010 Patentblatt 2010/40**

(21) Anmeldenummer: **05728230.3**

(22) Anmeldetag: **26.02.2005**

(51) Int Cl.:
***C08G 61/12*** *(2006.01)* ***H01B 1/12*** *(2006.01)*

(86) Internationale Anmeldenummer:
**PCT/EP2005/002048**

(87) Internationale Veröffentlichungsnummer:
**WO 2005/087836 (22.09.2005 Gazette 2005/38)**

(54) **VERWENDUNG VON FUNKTIONSSCHICHTEN FÜR OPTISCHE ANWENDUNGEN AUF BASIS VON POLYTHIOPHENEN**

USE OF FUNCTIONAL LAYERS FOR OPTICAL APPLICATIONS BASED ON POLYTHIOPHENES

UTILISATION DE COUCHES FONCTIONNELLES POUR DES UTILISATIONS OPTIQUES A BASE DE POLYTHIOPHENES

(84) Benannte Vertragsstaaten:
**AT BE BG CH CY CZ DE DK EE ES FI FR GB GR HU IE IS IT LI LT LU MC NL PL PT RO SE SI SK TR**

(30) Priorität: **11.03.2004 DE 102004012319**

(43) Veröffentlichungstag der Anmeldung:
**06.12.2006 Patentblatt 2006/49**

(73) Patentinhaber: **H.C. Starck Clevios GmbH**
**38642 Goslar (DE)**

(72) Erfinder:
- **ELSCHNER, Andreas**
  **45479 Mülheim (DE)**
- **GUNTERMANN, Udo**
  **47800 Krefeld (DE)**
- **JONAS, Friedrich**
  **52066 Aachen (DE)**

(74) Vertreter: **Herzog, Martin et al**
**Herzog Fiesser & Partner**
**Patentanwälte**
**Immermannstrasse 59**
**40210 Düsseldorf (DE)**

(56) Entgegenhaltungen:
**EP-A- 1 003 179**
**EP-A- 1 338 617**
**US-A1- 2003 098 946**
**US-A1- 2003 108 767**
**US-A1- 2004 026 121**
**US-B1- 6 452 711**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 1 727 847 B1

## Beschreibung

Die Erfindung betrifft die Verwendung einer transparenten Funktionsschichten aus elektrisch leitfähigen Polymeren, deren Herstellung und deren Verwendung in optischen Aufbauten.

Die optischen Eigenschaften eines Körpers werden durch seine Form und seine Materialeigenschaften bestimmt. Die für die Optik relevanten Materialeigenschaften sind der Brechungsindex n und die Absorptionskonstante k (vgl. Born, Max, Principles of Optics. 6th ed. 1.Optics - Collected works ISBN 0-08-026482-4). Durch Aufbringen von Funktionsschichten, die aus transparenten Materialien bestehen und sich bzgl. n und/oder k zumindestens in Teilen des elektromagnetischen Strahlungsspektrums vom. Träger unterscheiden, lassen sich die optischen Eigenschaften modifizieren. Aufgrund dieser Unterschiede in n und/oder k kommt es an der Grenzfläche wischen der Funktionsschicht und dem Träger zu Reflexion von Strahlung. Die Fresnelschen Formeln (vgl. Born, Max S.38ff) beschreiben dabei die Verteilung von reflektierter, absorbierter und transmittierter Strahlung.

Beispiele solcher optischer Funktionsschichten sind: Antireflexschichten auf optischen Elementen, Wärmeschutzschichten auf Verscheibungen, Cladding-Layer auf Glasfasern, Interferenzschichten auf Perlglanzpigmenten etc.

Die wirtschaftliche Bedeutung solcher optischen Funktionsschichten ist hoch, da sich durch diese die optischen Eigenschaften eines ganzen Körpers relativ einfach verändern lassen.

Als transparente optische Funktionsschichten kommen Materialien in Frage, die elektrisch leitfähig sind, z.B. TCO-Schichten (Transparent Conducting Oxides), wie Indium-Zinnoxid (ITO), Antimon-Zinnoxid (ATO) oder dünne Metallschichten oder die elektrisch isolierend sind, wie z.B. Titandioxid, Siliziumdioxid, Kryolith, Magnesiumfluorid. Die Abscheidung dieser anorganischen Schichten erfolgt durch Sputtern, reaktives Sputtern oder thermisches Verdampfen im Vakuum und ist damit aufwendig und kostenintensiv.

Anorganische optische Funktionsschichten haben als Nachteile:

a) hohe Prozesskosten bei der Abscheidung, da Vakuumanlagen notwendig sind,

b) hohe Materialkosten, insbesondere bei ITO-, ATO- und Metallschichten,

c) Sprödigkeit der Schichten, insbesondere der Metall-Oxid-Schichten,

d) die Abscheidung und/oder Nachtemperung der Schichten erfolgt bei hohen Temperaturen T >200˚C,

e) Brechungsindex' der oxidischen Schichten ist im sichtbaren Spektralbereich, d.h. im Wellenlängenbereich 400nm < $\lambda$ < 760nm, hoch (n >1.3) und nur schwer modifizierbar.

Es bestand daher weiterhin Bedarf an optischen Funktionsschichten, die ähnliche oder bessere Eigenschaften als anorganische optische Funktionsschichten haben.

Aufgabe der vorliegenden Erfindung war es somit, optische Funktionsschichten herzustellen, die die herkömmlichen teuren anorganischen optischen Funktionsschichten ersetzen können, ohne jedoch die vorangehend aufgeführten Nachteile aufzuweisen.

Überraschend wurde gefunden, dass sich eine transparente Schicht durch Aufbringen einer Lösung bestehend aus Thiophenmonomeren und Oxidationsmitteln herstellen lässt, die in Teilen des sichtbaren Spektralbereichs einen Brechungsindex n < 1.3 hat und die die Anforderungen an eine optische Funktionsschicht erfüllt.

Gegenstand der vorliegenden Erfindung ist daher eine transparente optische Funktionsschicht, **dadurch gekennzeichnet, dass** sie in Teilen des sichtbaren Spektralbereichs, insbesondere in einem Intervall von wenigstens 50 nm, bevorzugt von wenigstens 100 nm umfassenden Wellenlängenbereich, einen Brechungsindex n < 1.3 hat und wenigstens ein elektrisch leitfähiges Polymer, das wenigstens ein Polythiophen mit wiederkehrenden Einheiten der allgemeinen Formel (I) enthält,

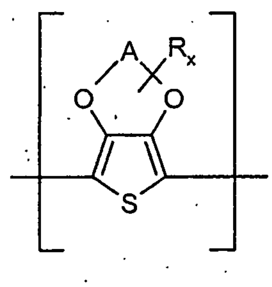

(I)

worin

A für einen gegebenenfalls substituierten $C_1$-$C_5$-Alkylenrest, bevorzugt für einen gegebenen- falls substituierten $C_2$-$C_3$-Alkylenrest, steht,

R für einen linearen oder verzweigten, gegebenenfalls substituierten $C_1$-$C_{18}$-Alkylrest, bevorzugt linearen oder verzweigten, gegebenenfalls substituierten $C_1$-$C_{14}$-Alkylrest, einen gegebenenfalls substituierten $C_5$-$C_{12}$-Cycloalkylrest, einen gegebenenfalls substituierten $C_6$-$C_{14}$-Arylrest, einen gegebenenfalls substituierten $C_7$-$C_{18}$-Aralkylrest, einen gegebenen- falls substituierten $C_1$-$C_4$-Hydroxyalkylrest, bevorzugt gegebenenfalls substituierten $C_1$-$C_2$- Hydroxyalkylrest, oder einen Hydroxylrest steht,

x für eine ganze Zahl von 0 bis 8 steht, bevorzugt von 0 bis 6, besonders bevorzugt für 0 oder 1

steht und

für den Fall, dass mehrere Reste R an A gebunden sind, diese gleich oder unterschiedlich sein können.

Die allgemeine Formel (I) ist so zu verstehen, dass x Substituenten R an den Alkylenrest A gebunden sein können.

Weitere elektrisch leitfähige Polymere, die ebenfalls in einer alternativen Ausführung erfindungsgemäß eingesetzt werden können, sind gegebenenfalls substituierte Polypyrrole oder gegebenenfalls substituierte Polyaniline.

Als elektrisch leitfähige Polymere sind hier Polymere mit einem spezifischen Widerstand von höchstens $10^8\ \Omega \cdot cm$ zu versehen.

In bevorzugten Ausführungsformen sind die Polythiophene mit wiederkehrenden Einheiten der allgemeinen Formel (I) solche mit wiederkehrenden Einheiten der allgemeinen Formel (Ia),

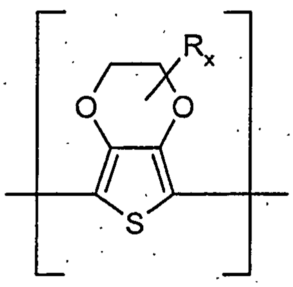

(Ia)

worin

R und x die oben genannte Bedeutung haben.

In weiteren bevorzugten Ausführungsformen sind die Polythiophene mit wiederkehrenden Einheiten der allgemeinen Formel (I) solche mit wiederkehrenden Einheiten der allgemeinen Formel (Iaa)

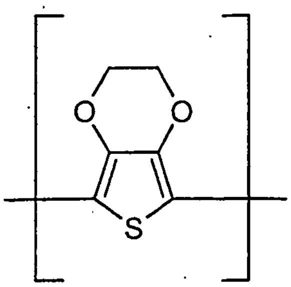

(Iaa) .

Unter dem Präfix Poly- ist im Rahmen der Erfindung zu verstehen, dass mehr als eine gleiche oder verschiedene wiederkehrende Einheit im Polymeren bzw. Polythiophen enthalten ist. Die Polythiophene enthalten insgesamt y wiederkehrende Einheiten der allgemeinen Formel (I), wobei y eine ganze Zahl von 2 bis 2000, bevorzugt 2 bis 100, sein kann. Die wiederkehrenden Einheiten der allgemeinen Formel (I) können innerhalb eines Polythiophens jeweils gleich oder verschieden sein. Bevorzugt sind Polythiophene mit jeweils gleichen wiederkehrenden. Einheiten der allgemeinen Formel (I).

An den Endgruppen tragen die Polythiophene bevorzugt jeweils H.

In einer besonders bevorzugten Ausführungsform ist das Polythiophen mit wiederkehrenden Einheiten der allgemeinen Formel (I) Poly(3,4-ethylendioxythiophen), d.h. ein Homopolythiophen aus wiederkehrenden Einheiten der Formel (Iaa).

In einer weiteren bevorzugten Ausführungsform der Erfindung enthält die Funktionsschicht neben-Polythiophen der allgemeinen Formel (I) als polymeres Anion ein Anion einer polymeren Carbon- oder Sulfonsäure. Besonders bevorzugt handelt es sich hierbei um das Anion der Polystyrolsulfonsäure.

$C_1$-$C_5$-Alkylenreste A sind im Rahmen der Erfindung: insbesondere Methylen, Ethylen, n-Propylen, n-Butylen oder n-Pentylen. $C_1$-$C_{18}$-Alkyl steht im Rahmen der Erfindung insbesondere für lineare oder verzweigte $C_1$-$C_{18}$-Alkyheste wie beispielsweise Methyl, Ethyl, n- oder iso-Propyl, n-, iso-, sec- oder tert-Butyl, n-Pentyl, 1-Methylbutyl, 2-Methylbutyl, 3-Methylbutyl, 1-Ethylpropyl, 1,1-Dimethylpropyl, 1,2-Dimethylpropyl, 2,2-Dimethylpropyl, n-Hexyl, n-Heptyl, n-Octyl; 2-Ethylhexyl, n-Nonyl, n-Decyl, n-Undecyl, n-Dodecyl, n-Tridecyl, n-Tetradecyl, n-Hexadecyl oder n-Octadecyl, $C_5$-$C_{12}$-Cycloalkyl für $C_5$-$C_{12}$-Cycloalkylreste wie beispielsweise Cyclopentyl, Cyclohexyl, Cycloheptyl, Cyclooctyl, Cyclononyl oder Cyclodecyl, $C_5$-$C_{14}$-Aryl für $C_5$-$C_{14}$-Aryheste wie beispielsweise Phenyl oder Naphthyl, und $C_7$-$C_{18}$-Aralkyl für $C_7$-$C_{18}$-Aralkylreste wie beispielsweise Benzyl, o-, m-, p-Tolyl, 2,3-, 2,4-, 2,5-, 2,6-, 3,4-, 3,5-Xylyl oder Mesityl. Die vorangehende Aufzählung dient der beispielhaften Erläuterung der Erfindung und ist nicht als abschließend zu betrachten.

Als gegebenenfalls weitere Substituenten der $C_1$-$C_5$-Alkylenreste A kommen zahlreiche organische Gruppen in Frage, beispielsweise Alkyl-, Cycloalkyl-, Aryl-, Halogen-, Ether-, Thioether-, Disulfid-, Sulfoxid-, Sulfon-, Sulfonat-, Amino-, Aldehyd-, Keto-, Carbonsäureester-, Carbonsäure-, Carbonat-, Carboxylat-, Cyano-, Alkylsilan- und Alkoxysilangruppen sowie Carboxylamidgruppen. Die erfindungsgemäße transparente optische Funktionsschicht kann auf ein beliebiges transparentes Substrat aufgebracht sein. Bei einem solchen Substrat kann es sich beispielsweise um Glas, Dünnstglas (flexibles Glas) oder Kunststoff handeln.

Besonders geeignete Kunststoffe sind: Polycarbonate, Polyester wie z.B. PET und PEN (Polyethylenterephthalat bzw. Polyethylennaphthalindicarboxylat), Copolycarbonate, Polysulfon, Polyethersulfon (PES), Polyimid, Polyethylen, Polypropylen oder cyclische Polyolefine bzw. cyclische Olefincopolymere (COC), hydrierte Styrolpolymere oder hydrierte Styrolcopolymere.

Geeignete Polymerunterlagen können beispielsweise Folien wie Polyesterfolien, PES-Folien der Firma Sumitomo oder Polycarbonatfolien der Firma Bayer AG (Makrofol®) sein.

Zwischen dem Substrat und der Funktionsschicht kann sich eine Haftvermittlerschicht befinden. Geeignete Haftvermittler sind beispielsweise Silane. Bevorzugt sind Epoxysilane, wie beispielsweise 3-Glycidoxypropyltrimethoxysilan (Silquest® A187, Fa. OSi specialities). Es können auch andere Haftvermittler mit hydrophilen Oberflächeneigenschaften verwendet werden. So wird z.B. eine dünne Schicht aus PEDT:PSS (Poly3,4-ethylendioxithiophen: Polystyrolsulfonsäure) als geeigneter Haftvermittler für PEDT Poly3,4-ethylendioxithiophen beschrieben (Hohnholz et al., Chem. Commun. 2001, 2444-2445).

Die erfindungsgemäße polymere optische Funktionsschicht hat gegenüber den eingangs beschriebenen bekannten anorganischen optischen Funktionsschichten folgende Vorteile:

Sie ist

a) einfach aus Lösung auf ein beliebiges Substrat aufbringbar, somit entfallen kostspielige Abscheideverfahren im Vakuum,

b) nicht spröde und damit auch für flexible Substrate geeignet,

c) hat einen niedrigen Brechungsindex im sichtbaren Spektralbereich, der sich durch Zugabe anderer transparenter Polymere einfach anpassen lässt.

Die Herstellung erfolgt zweckmäßigerweise so, dass die Schicht enthaltend wenigstens ein leitfähiges Polymer aus Vorstufen zur Herstellung leitfähiger Polymere entsprechend Formel (I) oder Anilin oder Pyrrol gegebenenfalls in Form von Lösungen direkt in situ auf einem geeigneten Substrat mittels chemischer oxidativer Polymerisation in Gegenwart eines oder mehrerer Oxidationsmittel oder mittels Elektropolymerisation hergestellt wird. Auf diese Schicht wird insbesondere gegebenenfalls nach Trocknung und Waschen eine Schicht enthaltend wenigstens ein polymeres Anion und wenigstens ein Polythiophen mit wiederkehrenden Einheiten der allgemeinen Formel (I) aus einer Dispersion enthaltend wenigstens ein polymeres Anion und wenigstens ein Polythiophen mit wiederkehrenden Einheiten der allgemeinen Formel (I) aufgebracht.

Weiterer Gegenstand der vorliegenden Erfindung ist daher ein Verfahren zur Herstellung einer erfindungsgemäßen polymeren optischen Funktionsschicht auf einem Substrat, **dadurch gekennzeichnet, dass** die Schicht enthaltend wenigstens ein leitfähiges Polymer hergestellt wird, indem auf dem Substrat Vorstufen zur Herstellung leitfähiger Polymere wie Pyrrol oder Anilin oder insbesondere ein Thiophen entsprechend der allgemeinen Formel (II)

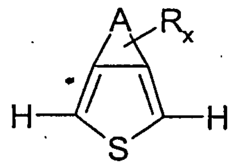

(II)

in der A, R und x die oben zu Formel (I) angegebene Bedeutung haben, gegebenenfalls in Form von Lösungen aufgebracht werden und chemisch oxidativ in Gegenwart eines oder mehrerer Oxidationsmittel oder elektrochemisch zu den leitfähigen Polymeren polymerisiert werden.

Als geeignete Substrate kommen die vorangehend bereits aufgeführten in Frage. Das Substrat kann vor Aufbringen der Schicht enthaltend wenigstens ein leitfähiges Polymer mit einem Haftvermittler behandelt werden. Eine solche Behandlung kann beispielsweise durch Spincoating, Tränkung, Gießen, Auftropfen, Spritzen, Aufsprühen, Aufrakeln, Bestreichen oder Bedrukken, beispielsweise Ink-jet-, Sieb-, Kontakt- oder Tampondrucken erfolgen.

Unter Vorstufen für die Herstellung leitfähiger Polymere, im Folgenden auch als Vorstufen bezeichnet, werden entsprechende Monomere oder deren Derivate verstanden. Es können auch Mischungen von unterschiedlichen Vorstufen verwendet werden. Geeignete monomere Vorstufen sind beispielsweise gegebenenfalls substituierte Thiophene, Pyrrole oder Aniline, bevorzugt gegebenenfalls substituierte Thiophene der allgemeinen Formel (II),

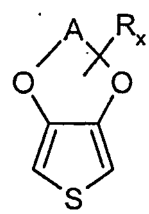

(II)

worin

A, R und x die oben genannte Bedeutung haben,

besonders bevorzugt gegebenenfalls substituierte 3,4-Alkylendioxythiophene der allgemeinen Formel (IIa)

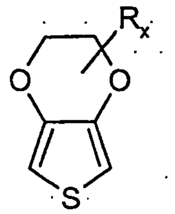

(IIa).

In einer bevorzugten Ausführungsform werden als monomere Vorstufen 3,4-Alkylendioxythiophene der Formel (IIaa)

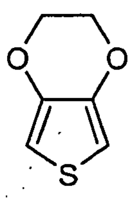

(IIaa)

eingesetzt.

Unter Derivaten dieser monomeren Vorstufen werden im Sinne der Erfindung beispielsweise Dimere oder Trimere dieser monomeren Vorstufen verstanden. Es sind auch höhermolekulare Derivate, d.h. Tetramere, Pentamere etc. der monomeren Vorstufen als Derivate möglich. Die Derivate können sowohl aus gleichen wie unterschiedlichen Monomereinheiten aufgebaut sein und in reiner Form sowie im Gemisch untereinander und/ oder mit den monomeren Vorstufen eingesetzt werden. Auch oxidierte oder reduzierte Formen dieser Vorstufen sind im Sinne der Erfindung von dem Begriff "Vorstufen" umfasst, sofern bei ihrer Polymerisation die gleichen leitfähigen Polymeren entstehen wie bei den vorangehend aufgeführten Vorstufen.

Als Substituenten für die Vorstufen, insbesondere für die Thiophene, bevorzugt für die 3,4-Alkylendioxythiophene kommen die für die allgemeine Formel (I) für R genannten Reste in Frage.

Verfahren zur Herstellung der monomeren Vorstufen für die Herstellung leitfähiger Polymere sowie deren Derivaten sind dem Fachmann bekannt und beispielsweise in L. Groenendaal, F. Jonas, D. Freitag, H. Pielartzik & J. R. Reynolds, Adv. Mater. 12 (2000) 481 - 494 und darin zitierter Literatur beschrieben.

Die Vorstufen können gegebenenfalls in Form von Lösungen eingesetzt werden. Als geeignete Lösungsmittel für die Vorstufen seien vor allem folgende unter den Reaktionsbedingungen inerten organischen Lösungsmittel genannt: aliphatische Alkohole wie Methanol, Ethanol, i-Propanol und Butanol; aliphatische Ketone wie Aceton und Methylethylketon; aliphatische Carbonsäureester wie Essigsäureethylester und Essigsäurebutylester; aromatische Kohlenwasserstoffe wie Toluol und Xylol; aliphatische Kohlenwasserstoffe wie Hexan, Heptan und Cyclohexan; Chlorkohlenwasserstoffe wie Dichlormethan und Dichlorethan; aliphatische Nitrile wie Acetonitril, aliphatische Sulfoxide und Sulfone wie Dimethylsulfoxid und Sulfolan; aliphatische Carbonsäureamide wie Methylacetamid, Dimethylacetamid und Dimethylformamid; aliphatische.und araliphatische Ether wie Diethylether und Anisol. Weiterhin kann auch Wasser oder ein Gemisch aus Wasser mit den vorgenannten organischen Lösungsmitteln als Lösungsmittel verwendet werden.

Die Lösungen können außerdem weitere Komponenten wie ein oder mehrere in organischen Lösungsmitteln lösliche organische Binder wie Polyvinylacetat, Polycarbonat, Polyvinylbutyral, Polyacrylsäureester, Polymethacrylsäureester, Polystyrol, Polyacrylnitril, Polyvinylchlorid, Polybutadien, Polyisopren, Polyether, Polyester, Silicone, Styrol/Acrylsäureester-, Vinylacetat/ Acrylsäureester- und Ethylen/Vinylacetat-Copolymerisate oder wasserlösliche Binder wie Polyvinylalkohole, Vernetzer wie Polyurethane bzw. Polyurethandispersionen, Polyacrylate, Polyolefindispersionen, Epoxysilane, wie 3-Glycidoxypropyltrialkoxysilan, und/oder Additive wie z.B. Imidazol oder oberflächenaktive Stoffe zugesetzt werden. Weiterhin können Alkoxysilanhydrolysate, z.B. auf Basis von Tetraethoxysilan, zur Erhöhung der Kratzfestigkeit bei Beschichtungen zuge-’ setzt werden oder um den Brechungsindex der In-Situ-Schicht gezielt zu erhöhen.

Für den Fall, dass die Vorstufen chemisch oxidativ zu den leitfähigen Polymeren polymerisiert werden, ist die Anwesenheit eines oder mehrerer Oxidationsmittel erforderlich.

Als Oxidationsmittel können alle dem Fachmann bekannten für die oxidative Polymerisation von Thiophenen, Anilinen oder Pyrrolen geeignete Metallsalze verwendet werden.

Geeignete Metallsalze sind Metallsalze von Haupt- oder Nebengruppenmetallen, letztere im Folgenden auch als Übergangsmetallsalze bezeichnet, des Periodensystems der Elemente. Geeignete Übergangsmetallsalze sind insbesondere Salze einer anorganischen oder organischen Säure oder organische Reste aufweisenden anorganischen Säure von Übergangsmetallen, z.B. von Eisen(III), Kupfer(II), Chrom(VI), Cer(IV), Mangan(IV), Mangan(VII) und Ruthenium(III).

Bevorzugte Übergangsmetallsalze sind solche des Eisen(III). Eisen(III)-Salze sind häufig preiswert, leicht erhältlich und können leicht gehandhabt werden, z.B. die Eisen(III)-Salze anorganischer Säuren, beispielsweise Eisen(III)halogenide (z.B. $FeCl_3$) oder Eisen (III)-Salze anderer anorganischer Säuren, wie $Fe(ClO_4)_3$ oder $Fe_2(SO_4)_3$, und die Eisen(III)-Salze organischer Säuren und organische Reste aufweisender anorganischer Säuren.

Als Eisen(III)-Salze organische Reste aufweisender anorganischer Säuren seien beispielsweise die Eisen(III)-Salze der Schwefelsäuremonoester von $C_1$-$C_{20}$-Alkanolen, z.B. das Eisen(III)-Salz des Laurylsülfates genannt.

Besonders bevorzugte Übergangsmetallsalze sind solche einer organischen Säure, insbesondere Eisen(III)-Salze organischer Säuren.

Als Eisen(III)-Salze organischer Säuren seien beispielsweise genannt: die Eisen(III)-Salze von $C_1$-$C_{20}$-Alkansulfonsäuren, wie der Methan-, Ethan-, Propan-, Butan- oder höherer Sulfonsäuren wie der Dodecansulfonsäure, von aliphatischen Perfluorsulfonsäuren, wie der Trifluormethansulfonsäure, der Perfluorbutansulfonsäure oder der Perfluoroctansulfonsäure, von aliphatischen $C_1$-$C_{20}$-Carbonsäuren wie der 2-Ethylhexylcarbonsäure, von aliphatischen Perfluorcarbonsäuren, wie der Trifluoressigsäure oder der Perfluoroctansäure, und von aromatischen, gegebenenfalls durch $C_1$-$C_{20}$-Alkylgruppen substituierten Sulfonsäuren wie der Benzolsulfonsäure, o-Toluolsulfonsäure, p-Toluolsulfonsäure oder der Dodecylbenzolsulfonsäure und von. Cycloalkansulfonsäuren wie Camphersulfonsäure.

Es können auch beliebige Gemische dieser vorgenannten Eisen(III)-Salze organischer Säuren eingesetzt werden.

Die Verwendung der Eisen(III)-salze organischer Säuren und der organischen Reste aufweisenden anorganischen Säuren hat den großen Vorteil, dass sie nicht korrosiv wirken.

Ganz besonders bevorzugt als Metallsalze sind Eisen(III)-p-toluolsulfonat, Eisen(III)-o-toluolsulfonat oder einer Mischung aus Eisen(III)-p-toluolsulfonat und Eisen(III)-o-toluolsulfonat.

In bevorzugten Ausführungsformen sind die Metallsalze vor ihrem Einsatz mit einem Ionenaustauscher, vorzugsweise einem basischen Anionenaustauscher, behandelt worden. Beispiele für geeignete Ionenaustauscher sind mit tertiären Aminen funktionalisierte makroporöse Polymerisate aus Styrol und Divinylbenzol wie sie z.B. unter dem Handelnamen Lewatit® von der Bayer AG, Leverkusen vertrieben werden.

Weiterhin geeignete Oxidationsmittel sind Peroxoverbindungen wie Peroxodisulfate (Persulfate), insbesondere Ammonium- und Alkaliperoxodisulfate, wie Natrium- und Kaliumperoxodisulfat, oder Alkaliperborate - gegebenenfalls in Anwesenheit katalytischer Mengen an Metallionen, wie Eisen-, Cobalt-, Nickel-, Molybdän- oder Vanadiumionen - sowie Übergangsmetalloxide, wie z.B. Braunstein (Mangan(IV)oxid) oder Cer (IV)oxid.

Für die oxidative Polymerisation der Thiophene der Formel (II) werden theoretisch je Mol Thiophen 2,25 Äquivalente Oxidationsmittel benötigt (siehe z.B. J. Polym. Sc. Part A Polymer Chemistry Vol. 26, S. 1287 (1988)). Es können aber auch niedrigere oder höhere Äquivalente an Oxidationsmittel eingesetzt werden. Im Rahmen der Erfindung wird je Mol Thiophen bevorzugt ein Äquivalent oder mehr, besonders bevorzugt 2 Äquivalente oder mehr Oxidationsmittel eingesetzt.

Bevorzugt können die Anionen des verwendeten Oxidationsmittels als Gegenionen dienen, so dass im Falle der chemischen oxidativen Polymerisation eine Zugabe zusätzlicher Gegenionen nicht zwingend erforderlich ist.

Die Oxidationsmittel können gemeinsam mit oder getrennt von den Vorstufen - gegebenenfalls in Form von Lösungen - auf das Substrat aufgebracht werden. Bei getrennter Aufbringung von Vorstufen, Oxidationsmitteln und gegebenenfalls Gegenionen wird das Substrat vorzugsweise zunächst mit der Lösung des Oxidationsmittels und gegebenenfalls der Gegenionen und anschließend mit der Lösung der Vorstufen beschichtet. Bei der bevorzugten gemeinsamen Aufbringung von Thiophenen, Oxidationsmittel und gegebenenfalls Gegenionen wird die Oxidschicht des Anodenkörpers nur mit einer, nämlich einer Thiophene, Oxidationsmittel und gegebenenfalls Gegenionen enthaltenden Lösung beschichtet. Als Lösungsmittel kommen in allen Fällen die vorangehend als für die Vorstufen geeignet beschriebenen Lösungsmittel in Frage.

Die Lösungen können außerdem als weitere Komponenten (Binder, Vernetzer etc.), die vorangehend bereits für die Lösungen der Vorstufen beschriebenen Komponenten enthalten.

Die auf das Substrat aufzubringenden Lösungen enthalten vorzugsweise 1 bis 30 Gew.-% der Vorstufen, vorzugsweise, der Thiophene der allgemeinen Formel (II) und gegebenenfalls 0 bis 50 Gew.-% Bindemittel, Vernetzer und/oder Additive, beide Gewichtsprozente bezogen auf das. Gesamtgewicht der Lösung.

Die Lösungen werden nach bekannten Verfahren, z.B. durch Spincoating, Tränkung, Gießen, Auftropen, Spritzen, Aufsprühen, Aufrakeln, Bestreichen oder Bedrucken, beispielsweise Ink-jet-, Sieb- oder Tampondrucken auf das Substrat aufgebracht.

Das Entfernen von gegebenenfalls vorhandenem Lösungsmittel nach dem Aufbringen der Lösungen kann durch einfaches Verdampfen bei Raumtemperatur erfolgen. Zur Erzielung höherer Verarbeitungsgeschwindigkeiten ist es jedoch vorteilhafter, die Lösungsmittel bei erhöhten Temperaturen, z.B. bei Temperaturen von 20 bis zu 300°C, bevorzugt 40 bis zu 250°C, zu entfernen. Eine thermische Nachbehandlung kann unmittelbar mit dem Entfernen des Lösungsmittel verbunden oder aber auch in zeitlichem Abstand von der Fertigstellung der Beschichtung vorgenommen werden. Die Lösungsmittel können vor, während oder nach der Polymerisation entfernt werden.

Die Dauer der Wärmebehandlung kann in Abhängigkeit von der Art des für die Beschichtung verwendeten Polymers 5 Sekunden bis mehrere Stunden betragen. Für die thermische Behandlung können auch Temperaturprofile mit unterschiedlichen Temperaturen und Verweilzeiten eingesetzt werden.

Die Wärmebehandlung kann z.B. in der Weise ausgeführt werden, dass man die beschichteten Substrate mit einer solchen Geschwindigkeit durch eine auf der gewünschten Temperatur befmdliche Wärmekammer bewegt, dass die gewünschte Verweilzeit bei der gewählten Temperatur erreicht wird, oder mit einer auf

der gewünschten Temperatur befindlichen Heizplatte für die gewünschte Verweilzeit in Kontakt bringt. Des Weiteren kann die Wärmebehandlung beispielsweise in einem Wärmeofen oder mehreren Wärmeöfen mit jeweils unterschiedlichen Temperaturen erfolgen.

Nach dem Entfernen der Lösungsmittel (Trocknen) und gegebenenfalls nach der thermischen Nachbehandlung kann es vorteilhaft sein, das überschüssige Oxidationsmittel und Restsalze aus der Schicht mit einem geeigneten Lösungsmittel, bevorzugt Wasser oder Alkoholen, auszuwaschen. Unter Restsalzen sind hier die Salze der reduzierten Form des Oxidationsmittels und gegebenenfalls weitere vorhandene Salze zu verstehen.

Die elektrochemische Polymerisation kann nach dem Fachmann bekannten Verfahren durchgeführt werden.

Sofern die Thiophene der allgemeinen Formel (II) flüssig sind, kann die Elektropolymerisation in An- oder Abwesenheit von unter den Bedingungen der Elektropolymerisation inerten Lösungsmitteln vorgenommen werden; die Elektropolymerisation von festen Thiophenen der allgemeinen Formel (II) wird in Gegenwart von unter den Bedingungen der elektrochemischen Polymerisation inerten Lösungsmitteln durchgeführt. In bestimmten Fällen kann es vorteilhaft sein, Lösungsmittelgemische einzusetzen und/oder den Lösungsmitteln Lösungsvermittler (Detergentien) zuzusetzen.

Als unter den Bedingungen der Elektropolymerisation inerte Lösungsmittel seien beispielsweise genannt: Wasser; Alkohole wie Methanol und Ethanol; Ketone wie Acetophenon; halogenierte Kohlenwasserstoffe wie Methylenchlorid, Chloroform, Tetrachlorkohlenstoff und Fluorkohlenwasserstoffe; Ester wie Ethylacetat und Butylacetat; Kohlensäureester wie Propylencarbonat; aromatische Kohlenwasserstoffe wie Benzol, Toluol, Xylol; aliphatische Kohlenwasserstoffe wie Pentan, Hexan, Heptan und Cyclohexan; Nitrile wie Acetonitril und Benzonitril; Sulfoxide wie Dimethylsulfoxid; Sulfone wie Dimethylsulfon, Phenylmethylsulfon und Sulfolan; flüssige aliphatische Amide wie Methylacetamid, Dimethylacetamid, Dimethylformamid, Pyrrolidon, N-Methylpyrrolidon, N-Methylcaprolactam; aliphatische und gemischt aliphatisch-aromatische Ether wie Diethylether und Anisol; flüssige Harnstoffe wie Tetramethylharnstoff oder N, N-Dimethyl-imidazolidinon.

Für die Elektropolymerisation werden die Thiophene der allgemeinen Formel (II) bzw. deren Lösungen mit Elektrolytzusätzen versetzt. Als Elektrolytzusätze werden vorzugsweise freie Säuren oder übliche Leitsalze verwendet, die eine gewisse Löslichkeit in den verwendeten Lösungsmitteln aufweise. Als Elektrolytzusätze haben sich z.B. bewährt: freie Säuren wie p-Toluolsulfonsäure, Methansulfonsäure, ferner Salze mit Alkansulfonat-, aromatischen Sulfonat-, Tetrafluoroborat-, Hexafluorophosphat-, Perchlorat-, Hexafluoroantimonat-, Hexafluoroarsenat- und Hexachloroantimonat-Anionen und Alkali-, Erdalkäli- oder gegebenenfalls alkylierten Ammonium-, Phosphonium-, Sulfonium- und Oxonium-Kationen.

Die Konzentrationen der monomeren Thiophene der allgemeinen Formel (II) können zwischen 0,01 und 100 Gew.-% (100 Gew.-% nur bei flüssigem Thiophen) liegen; bevorzugt betragen die Konzentrationen 0,1 bis 20 Gew.-%, bezogen auf das Gesamtgewicht der Lösung.

Die Elektropolymerisation kann diskontinuierlich oder kontinuierlich durchgeführt werden.

Die Stromdichte für die Elektropolymerisation kann in weiten Grenzen schwanken; üblicherweise wird mit einer Stromdichte von 0,0001 bis 100 $mA/cm^2$, vorzugsweise 0,01 bis 40 $mA/cm^2$ garbeitet. Bei dieser Stromdichte stellt sich eine Spannung von etwa 0,1 bis 50 V ein.

Als Gegenionen eignen sich die oben bereits aufgeführten. Bei der elektrochemischen Polymerisation können diese Gegenionen der Lösung oder den Thiophenen gegebenenfalls als Elektrolytzusätze oder Leitsalze zugegeben werden.

Die elektrochemische oxidative Polymerisation der Thiophene der allgemeinen Formel (II) kann bei einer Temperatur von -78˚C bis zum Siedepunkt des gegebenenfalls eingesetzten Lösungsmittels vorgenommen werden. Bevorzugt wird bei einer Temperatur von -78˚C bis 250˚C, besonders bevorzugt von -20˚C bis 60˚C elektrochemisch polymerisiert.

Die Reaktionszeiten betragen in Abhängigkeit vom verwendeten Thiophen, dem verwendeten Elektrolyten, der gewählten Temperatur und der angewendeten Stromdichte vorzugsweise 1 Minute bis 24 Stunden.

Bei der elektrochemischen Polymerisation kann das Substrat, welches in der Regel nicht leitfähig ist, zunächst, wie in Groenendaal et al. Adv.Mat. 2003, 15, 855 beschrieben, mit einer dünnen transparenten Schicht eines leitfähigen Polymers beschichtet werden. Das so leitfähig beschichtete Substrat mit einem Oberflächenwiderstand von $\geq 10^4$ Ω/sq übernimmt bei der anschließenden Elektropolymerisation die Funktion der Pt-Elektrode. Die Schicht enthaltend das leitfähige Polymer wächst beim Anlegen einer Spannung darauf auf.

Da das oder die leitfähige(n) Polymer(e) in der Schicht enthaltend wenigstens ein leitfähiges Polymer direkt durch Polymerisation von Vorstufen in-situ auf dem Substrat erzeugt werden, wird diese Schicht im Folgenden auch als "in-situ-Schicht" bezeichnet. Der Begriff der in-situ-Abscheidung eines leitfähigen Polymers aus einer polymerisierbaren Lösung von Monomer und Oxidationsmittel ist in Fachkreisen allgemein bekannt.

Nach dem erfindungsgemäßen Verfahren ist eine polymere optische Funktionsschicht herstellbar, ohne dass aufwendige und teure CVD-, Aufdampf- oder Aufsputterverfahren notwendig sind. Dadurch wird unter anderem auch eine großflächige Anwendung des erfindungsgemäßen Verfahrens ermöglicht. Außerdem lässt sich die in-situ-Schicht bei niedrigen Temperaturen, vorzugsweise Raumtemperatur aufbringen. Das erfmdungsgemäße Verfahren ist somit auch für die Aufbringung auf polymere, flexible Substrate geeignet, die in der Regel nur Niedertemperaturprozesse vertragen und den Temperaturen des thermischen CVDs oder des reaktiven Sputterns bei der Abscheidung nicht standhalten.

Die erfindungsgemäße optische Funktionsschicht weist bevorzugt eine Transmission von $Y \geq 25\%$ auf. Die Transmission wird bestimmt nach der Messmethode, wie sie in der Vorschrift ASTM D 1003-00 beschrieben ist. Die Transmission wird dann entsprechend ASTM E 308 (Lichtart C,2* Beobachter) berechnet.

Die erfindungsgemäßen polymeren Schichten eignen sich hervorragend als optischen Funktionsschichten, wie Antireflexschichten auf optischen Elementen und Verscheibungen, Wärmeschutzschichten auf Verscheibungen, Cladding-Layer auf Glasfasern, Interferenzschichten auf Perlglanzpigmenten.

Die bevorzugte Funktionsschicht - bestehend aus einem Polydioxythiophen - zeichnet sich durch den besonderen Verlauf seiner Dispersions- und seiner Absorptionskurve aus und ist daher als optische Funktionsschicht besonders geeignet. Die Dispersionskurve beschreibt die spektrale Abhängigkeit des Brechungsindex: Die Absorptionskurve beschreibt die spektrale Abhängigkeit der Absorptionskonstanten.

Polymere optische Funktionsschichten basierend auf der erfindungsgemäßen Schicht sind in folgenden Anwendungen von Vorteil:

1.) Antireflexschichten auf Oberflächen (vgl. Born, Max, Principles of Optics, S.51ff)

Durch Aufbringen einer transparenten Funktionsschicht lassen sich Entspiegelungsschichten generieren, indem diese Schichten in definierten Dicken abgeschieden werden. Wenn die optische Weglänge dieser Schicht gleich einem Viertel der Wellenlänge ist, d.h. $n_L*d=\lambda/4$ kommt es zu destruktiver Interferenz der beiden an der Ober- und der Unterseite der Schicht reflektierten Teilstrahlen. Wenn die reflektierten Teilstrahlen gleiche Intensität haben, wird insgesamt kein Licht reflektiert. Damit die reflektierten Teilstrahlen gleiche-Intensität haben, sollte der Brechungsindex der Entspiegelungsschicht gleich dem geometrischen Mittel der Brechungsindizes von Luft und dem Träger sein , d.h. $n_L=\sqrt{(n_A*n_S)}$ (vgl. Born,Max S.64ff). Da $n_A=1$ und $n_S=1.5$ für Glas ist, sollte der Brechungsindex der aufgebrachten Antireflexschicht idealerweise $n_L=1.22$ betragen.

Als Entspiegelungsschichten werden üblicherweise transparente anorganische Materialen, z.B. Titandioxid, Siliciumdioxid, Kryolith, Magnesiumfluorid als dünner Film abgeschieden. Alle diese anorganischen Schichten haben einen Brechungsindex, der deutlich über dem gewünschten geometrischen Brechungsindex von n=1.22 liegt. Beispielsweise beträgt der Brechungsindex von Kryolite n=1.35 oder von MgF2 n=1.38. Transparente Festkörper mit einem niedrigen Brechungsindex von n < 1.3 werden bisher als Antireflexschichten nicht verwendet.

Aufgrund des zu hohen Brechungsindex werden daher Entspiegelungsschichten als Multischichtsysteme z.B. auf Glas abgeschieden. Dabei werden in alternierender Abfolge dünne anorganische Schichten mit verschiedenem Brechungsindex aufeinander deponiert; wie z.B. in US-A 4726654 beschrieben.

Die oben aufgeführten anorganischen Entspiegelungsschichten werden durch bekannte Dünnschichtdepositionsverfahren abgeschieden, wie thermisches Verdampfen, Sputtern, CVD (Chemical Vapor Deposition) u.a. Diese Verfahren sind aufwendig und damit teuer, da alle ein Vakuum benötigen und die Depositionsraten langsam sind.

Durch Aufbringen einer in-situ-PEDT enthaltenden Schicht auf PET-Folie oder Quarzglas wurde überraschend gefunden, dass sich die Reflexion eines Trägers im sichtbaren Spektralbereich deutlich erniedrigen lässt. Da die PEDT enthaltenden Schicht einen sehr niedrigen Brechungsindex von n = 0.8 - 1.3 im sichtbaren Spektralbereich hat bei gleichzeitig hoher Transparenz, lässt sich eine dünne Schicht dieses Materials als Entspiegelungsschicht nutzen.

Die Bestimmung der optischen Konstanten einer dünnen Schicht erfolgt nach zwei bekannten Methoden der Dünnschichtoptik indem die Reflexions- und Transmissionskurven von zwei Schichten mit unterschiedlicher Schichtdicke iterativ angepasst werden. Bei der ersten Methode wird n und k mit Hilfe der Fresnelschen Formeln iterativ berechnet. Bei der zweiten Methode wird das ETA-RT Gerät der Firma Steag Eta-Optik GmbH, Heinsberg, Deutschland und der dort integrierten Software zur Bestimmung der n- und k-Werte verwendet. Beide Verfahren liefern im ähnliche Ergebnisse.

Der niedrige Brechungsindex in weiten Teilen des sichtbaren Spektralbereichs der erfindungsgemäßen in-Situ-Schicht von n < 1.3 weist die folgenden Vorteile auf:

a) Der Brechungsindex der erfindungsgemäßen Schicht, kann - wie überraschend gefunden wurde - gezielt eingestellt werden, so dass diese dem geometrische Mittel der Brechungsindizes aus Luft $n_A$ und Substrat $n_S$ entspricht. Bereits mit einer einzelnen Schicht lassen sich so hohe Antireflexeffekte erzielen. Die Einstellung erfolgt, indem eine bestimmte Menge eines in der In-Situ-PEDT-Lösung löslichen Polymers mit einem Brechungindex $n_{ISP} < n_P$ mit der In-Situ-PEDT-Lösung gemischt wird. Der Brechungsindex der Schicht $n_L$ lässt sich dann einfach berechnen, entsprechend:

$$n_L = n_{ISP} * \rho_{ISP} + n_P * \rho_P,$$

mit $n_{ISP}$ und $n_P$ den Brechungsindizes der reinen in-Situ-PEDT- bzw. der reinen Polymerschicht und $\rho_{ISP}$ bzw. $\rho_P$ den entsprechenden Volumenanteilen. Geeignete Polymere mit $n_{ISP} < n_P$ und einer ausreichenden Löslichkeit in einer In-situ-PEDT-Lösung sind oben näher beschrieben.

b) Die in-situ-PEDT enthaltenden Schicht lässt sich sehr viel einfacher auf den gewünschten Träger aus Lösung aufbringen, indem kostengünstige Abscheideverfahren - wie oben näher ausgeführt - zum Einsatz kommen.

2.) Beschichtungsschicht auf Effektpigmenten
Beschichte Glimmerscheibchen werden als Perlglanz-Effektpigment zur Einfärbung von Lacken verwendet (vgl.Iridin®-Pigmente, Merck, Darmstadt). Der Perlglanzeffekt wird durch eine dünne Schicht erzeugt, die auf den Glimmerträger aufgefällt wird. Wie oben unter 1.) beschrieben, kommt es auch hier zu einem Interferenzphänomen. Bestimmte Bereiche des sichtbaren Spektralbereichs werden bevorzugt reflektiert bzw. absorbiert und dadurch entsteht der besondere Farbeindruck entsteht.
Üblicherweise werden diese Pigmente mit anorganischen Schichten wie z.B. $TiO_2$ oder $SiO_2$ beschichtet. Aufgrund des niedrigen Brechungsindex und seines einzigartigen spektralen Verlaufs ermöglicht eine dünne Schicht von PEDT Farbpigment mit neuen verbesserten Farbeigenschaften herzustellen.
3.) Infrarotreflexionsschicht auf Oberflächen
Die Aufheizung von geschlossenen Räumen hinter Glassscheiben, durch die das Sonnenlicht eindringen kann, lässt sich reduzieren, indem die Glasscheiben mit einer Infrarot reflektierenden Schutzschicht versehen werden (IR-Reflexions-Schicht). Da diese Schicht gleichzeitig im sichtbaren Spektralbereich transparent sein sollte, werden als IR-Reflex-Schicht für Glasscheiben üblicherweise anorganische Beschichtungen, wie Indiurn-Zinn-Oxid (ITO) oder Antimon-Zinn-Oxid verwendet (vgl. K-Glas).
Durch Aufbringen einer in-situ-PEDT enthaltenden Schicht auf PET-Folie oder Quarzglas wurde überraschend gefunden, dass sich die IR-Reflexion des Trägers im Wellenlängenbereich der Wärmestrahlung der Sonne, d.h. im Bereich $\lambda > 750$ nm deutlich erhöhen lässt. Dadurch wird weniger IR-Licht durchgelassen und die Aufwärmung des hinter der Scheibe liegenden Raums verringert.
4.) Wellenleiter, Cladding von Glasfasern
Optische Glasfasern werden mit einem Claddinglayer (vgl. Bergmann Schaefer, Band 3 Optik, S.449ff, 9.Auflage) beschichtet, um die empfindliche Oberfläche der Glasfasern vor Verkratzung zu schützen. Bei Glasfasern werden dazu die äußeren Bereiche der Glasfaser geeignet dotiert, d.h. gezielt mit Verunreinigungen versehen, um den Brechungsindex im relevanten spektralen Übertragungsbereich relativ zum Faserinneren zu erniedrigen. Das Signal bleibt aufgrund dieses Brechungsindexgradienten und der damit verbundenen Totalreflexion im Inneren der Faser und Störungen an der Oberfläche, wie z.B. Verkratzungen, wirken nicht mehr als Streuzentren. Der oben beschriebene Prozess der Dotierung von Glas im Aussenbereich hat den Nachteil, dass sich dieser Prozess nur während der Herstellung der Glasfaser realisieren lässt. Der Bereich der Totalreflexion ist dabei auf eine relativ schmalen Wellenlängenbereich beschränkt.
Aufgrund des niedrigen Brechungsindex von in-Situ-PEDT ist dieses Material auch als Claddinglayer für Glasfasern geeignet mit dem Vorteil, das sich diese Schicht auch noch nachträglich und einfach auf die Glas- oder Polymer-Lichtleiterfasern aufbringen lässt und die Totalreflexion in weiten Bereichen im sichtbaren und IR-Bereichs erhalten bleibt.

Der gefundene Effekt ist unerwartet, da bisher keine Polymere bekannt sind, die aus Lösung applizierbar sind und die einen Brechungsindex n <1.3 im sichtbaren Spektralbereich haben, bzw. hohe Reflexionseigenschaften für Wellenlängen im Nah-Infraroten Bereich.
Die Erfindung wird nachstehend beispielhaft mittels der Figuren erläutert.
Es zeigen:

Fig. 1 Ein Diagramm, das die Reflexion einer In-situ-PEDT-Schicht auf Quarz-Substrat in Abhängigkeit von der Wellenlänge wiedergibt im Vergleich mit einer bloßen Quarz- Schicht,

Fig. 2 ein Diagramm ähnlich Fig. 1 mit einer Poly-3,4-ethylen-dioxythiophen und Polysulfon- säure enthaltenden Schicht,

Fig. 3 ein Diagramm ähnlich Fig. 1 für die Messung an in-situ beschichteter und unbeschichteter PET-Folie,

Fig. 4 ein weiteres Diagramm ähnlich Fig. 3.

## Beispiele

### Beispiel 1

In-situ-PEDT-Schichten auf Quarzglas:

Auf gereinigte Quarzsubstrate wird Epoxysilan (Silquest® A187, Hersteller OSi specialities) mit 20 Teilen 2-Propanol verdünnt mit einem Spincoater aufgeschleudert und anschließend bei 50°C für 5 min an Luft getrocknet. Die Schichtdicken sind kleiner 20 nm. Eine Lösung bestehend aus 3,4-Ethylendioxythiophen (Baytron® M), einer 6 %igen Lösung aus Eisen(III)-(tosylat)$_3$ in Butanol, (Baytron® CB 40, Hersteller H.C. Starck GmbH) und Imidazol im Gew.-Verhältnis 1 : 20 : 0.5 wird angesetzt und filtriert (Millipore HV, 0,45 μm). Im Anschluss wird die Lösung mit einem Spincoater auf das mit Epoxysilan beschichtete Quarzsubstrat aufgeschleudert bei 1000 U/min. Anschließend wird die Schicht bei Raumtemperatur (RT, 23˚C) getrocknet und danach mit dest. Wasser sorgfältig gespült, um die Eisensalze zu entfernen. Nach Trocknung der Schichten beträgt die Schichtdicke ca. 155 nm. Die Schichten haben glatte Oberflächen mit einer Oberflächenrauhigkeit Ra < 5 nm. Die Leitfähigkeit der Schichten beträgt 550 S/cm. Die Transparenz der Schichten ist hoch. So beträgt die Transparenz einer 200nm dicken Schicht auf Glassubstrat Y > 50 %.

Die Reflexionsspektren der Schichten auf Quarz werden mit einem Spektralphotometer (PerkinElmer Lamda 900, ausgerüstet mit Ulbrichtkugel) nach DIN 5036 aufgenommen. In Figur 1 sind die Reflexionsspektren dargestellt. Deutlich ist zu erkennen, dass die Reflexion in weiten Teilen des sichtbaren Spektralbereichs niedriger ist als unbeschichtetes Quarzglas. Insbesondere bei 550 nm, dem Maximum der Augenempfmdlichkeitskurve, beträgt die Reflexion der 155 nm dicken In-Situ-PEDT Schicht auf Quarz nur 1.4 % gegenüber 6.8 % bei unbeschichtetem Quarz. Die In-Situ-PEDT-Schicht führt daher zu einer Entspiegelung des Quarzsubstrats im sichtbaren Spektralbereich.

Bei einer Wellenlänge von 2000 nm beträgt die Reflexion der In-Situ-PEDT-Schicht auf Quarz 51.5 % gegenüber 6.1 % bei unbeschichtetem Quarz. Die In-Situ-PEDT-Schicht reflektiert damit im Nah-IR-Bereich stärker als das Quarzsubstrat

**Beispiel 2**

Baytron P® AI4071-Schichten auf Quarzglas:

Auf gereinigte Quarzsubstrate wird eine Mischung aus Poly(3,4-ethylendioxythiophen) und Polystyrolsulfonsäure (1 : 2,5 Gew.-Teilen) Baytron P® AI4071 bei 1000 U/min aufgeschleudert. Anschließend wird die Schicht bei 200˚C getrocknet. Nach Trocknung der Schichten beträgt die Schichtdicke ca. 180 nm. Die Schichten haben glatte Oberflächen mit einer Oberflächenrauhigkeit Ra < 5 nm. Die Leitfähigkeit der Schichten beträgt 0.1 S/cm.

In Figur 2 sind die Reflexionsspektren dargestellt.

Bei einer Wellenlänge von 700 nm beträgt die Reflexion der Baytron P® AI4071 Schicht auf Quarz 4.8 % gegenüber 6.7 % bei unbeschichtetem Quarz. Die Baytron P® AI4071 -Schicht führt daher zu einer Entspiegelung des Quarzsubstrats im sichtbaren Spektralbereich.

Bei einer Wellenlänge von 2000 nm beträgt die Reflexion der Baytron P® AI4071 Schicht auf Quarz 16.2 % gegenüber 6.1 % bei unbeschichtetem Quarz. Die Baytron P® AI4071 -Schicht reflektiert damit im Nah-IR-Bereich stärker als das Quarzsubstrat

**Beispiel 3**

Wie in Beispiel 1 wird eine In-Situ-PEDT-Schicht auf Quarzglas abgeschieden und die Reflexions- und Transmissionsspekten gemessen, mit dem Unterschied dass die Umdrehungsgeschwindigkeit 2000 U/min beträgt und die Schichtdicke 95 nm beträgt.

**Beispiel 4**

Wie in Beispiel 2 wird eine Baytron P® AI4071-Schicht auf Quarzglas abgeschieden und die Reflexions- und Transmissionsspekten gemessen, mit dem Unterschied dass die Umdrehungsgeschwindigkeit 2000U/min beträgt und die Schichtdicke 100 nm beträgt.

**Beispiel 5**

Mit den entsprechend Beispiel 1 und 3 und Beispiel 2 und 4 hergestellten Schichten werden die Dispersions- und Absorptionskurven der In-Situ-PEDT-Schicht und der Baytron P® AI4I4071-Schicht auf Quarzglas bestimmt. Die Bestimmung erfolgt mit zwei unterschiedlichen Methoden, die übereinstimmende Ergebnisse liefern. Methode 1 ist ein Rechenprogramm, dass die Fresnelschen Formeln zugrunde legt und iterativ die n und k so lange anpasst bis die berechneten R- und T-Verläufe den gemessenen der beiden Proben mit unterschiedlicher Schichtdicke entsprechen. Methode 2 verwendet das ETA-RT Gerät der Firma Steag EtaOptik mit dem sich aus R- und T-Spektren dünner Schichten auf einem Substrat n und k bestimmen lassen. Beide Methoden liefern ein ähnliches Ergebnis, dass in Tabelle 1 zusammengefasst ist.

Aus Tabelle 1 folgt, dass eine In-Situ-PEDT-Schicht in weiten Teilen des sichtbaren Spektralbereiche einen Brechungsindex n < 1.3 hat, wohingegen eine Baytron P® AI4071-Schicht - die mit der PSS eine elektrisch nichtleitende Komponente enthält - einen höheren Brechungsindex hat.

**Tabelle 1:** Dispersions- und Absorptionskurven von In-Situ-PEDT und Baytron P AI4071

| | **AI4071** | | **In-Situ-PEDT** | |
|---|---|---|---|---|
| **λ (nm)** | **n** | **k** | **n** | **k** |
| **350** | 1.515 | 0.016 | 1.4825 | 0.0485 |
| **400** | 1.495 | 0.019 | 1.3945 | 0.069 |
| **450** | 1.477 | 0.023 | 1.316 | 0.1005 |
| **500** | 1.460 | 0.028 | 1.245 | 0.1435 |
| **550** | 1.446 | 0.035 | 1.182 | 0.1975 |
| **600** | 1.432 | 0.044 | 1.1255 | 0.262 |
| **650** | 1.420 | 0.053 | 1.081 | 0.3385 |
| **700** | 1.410 | 0.064 | 1.044 | 0.425 |

(fortgesetzt)

| | AI4071 | | In-Situ-PEDT | |
|---|---|---|---|---|
| **λ (nm)** | **n** | **k** | **n** | **k** |
| **750** | 1.400 | 0.076 | 1.014 | 0.523 |
| **800** | 1.392 | 0.089 | 0.9915 | 0.632 |
| **850** | 1.385 | 0.105 | | |

**Beispiel 6**

Wie in Beispiel 1 wird eine In-Situ-PEDT-Schicht abgeschieden und gemessen, mit dem Unterschied , dass die Lösung, bestehend aus Baytron® M , Baytron® CB 40 und DMSO im Gew.-Verhältnis 1 : 20 : 1,25 angesetzt wird und diese Lösung mit einem Rakel auf PET-Folie aufgebracht wird. Der verwendete Rakel führt zu einer Nassschichtdicke von d = 12 μm.

Die Reflexionsspektren der so beschichteten Folie sind im Vergleich zur unbeschichteten PET-Folie in Figur 3 des Anhangs dargestellt.

Die Reflexion ist mit der Beschichtung im sichtbaren Spektralbereich deutlich niedriger als ohne Beschichtung. So beträgt die Reflexion bei 490 nm R=3,62 % mit Beschichtung gegenüber R=9,9 % ohne Beschichtung. Im Nah-IR ist dagegen die Reflexion mit der Beschichtung höher, so beträgt die Reflexion bei 2400 nm R=46,9 % mit Beschichtung gegenüber R=6,5 % ohne Beschichtung.

Damit ist gezeigt, dass die erfindungsgemäße Schicht zu einer Reduzierung der Reflexion im sichtbaren Spektralbereich führt und zu einer Erhöhung der Reflexion im Nah-IR.

**Beispiel 7**

Wie in Beispiel 1 wird eine In-Situ-PEDT-Schicht abgeschieden und gemessen, mit dem Unterschied , dass die Lösung, bestehend aus Baytron® M , Baytron® CB 40, DMSO und ein Vernetzer auf Polyurethanbasis Desmotherm® 2170 (Hersteller Bayer AG) im Gew.-Verhältnis 1 : 20 : 1,25 : 0,5 angesetzt wird und diese Lösung mit einem Rakel auf PET-Folie aufgebracht wird. Der verwendete Rakel führt zu einer Nassschichtdicke von d = 12 μm.

Die Reflexionsspektren der so beschichteten Folie sind im Vergleich zur unbeschichteten PET-Folie in Figur 4 des Anhangs dargestellt.

Die Reflexion ist mit der Beschichtung im sichtbaren Spektralbereich deutlich niedriger als ohne Beschichtung. So beträgt die Reflexion bei 650 nm R = 2,60 % mit Beschichtung gegenüber R = 9,5 % ohne Beschichtung. Im Nah-IR ist dagegen die Reflexion mit der Beschichtung höher, so beträgt die Reflexion bei 2400 nm Wellenlänge R = 41,5 % mit Beschichtung gegenüber R = 6,5 % ohne Beschichtung.

Damit ist gezeigt, dass die erfindungsgemäße Schicht zu einer Reduzierung der Reflexion im sichtbaren Spektralbereich führt und zu einer Erhöhung der Reflexion im Nah-IR. Weiterhin zeigt dieses Beispiel insbesondere im Vergleich zu Beispiel 6, dass sich durch die Zugabe des Vernetzers Desmotherm 2170 bei gleichen Abscheidebedingungen der spektrale Verlauf der Reflexion sich verändern lässt.

**Patentansprüche**

1. Verwendung einer transparenten optischen Funktionsschicht, welche in Teilen des sichtbaren Spektralbereichs einen Brechungsindex n < 1.3 hat und wenigstens ein elektrisch leitfähiges Polymer enthält, das wenigstens ein Polythiophen mit wiederkehrenden Einheiten der allgemeinen Formel (I),

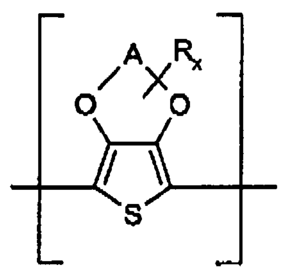

(I)

worin

A für einen gegebenenfalls substituierten $C_1$-$C_5$-Alkylenrest steht,
R für einen linearen oder verzweigten, gegebenenfalls substituierten $C_1$-$C_{18}$-Alkylrest, einen gegebenenfalls substituierten $C_5$-$C_{12}$- Cycloalkylrest, einen gegebenenfalls substituierten $C_6$-$C_{14}$-Arylrest, einen gegebenenfalls substituierten $C_7$-$C_{18}$-Aralkylrest, einen gege- benenfalls substituierten $C_1$-$C_4$-Hydroxyalkylrest oder einen Hydroxylrest steht,
x für eine ganze Zahl von 0 bis 8 steht und

für den Fall, dass mehrere Reste R an A gebunden sind, diese gleich oder unterschiedlich sein können, enthält,
als Antireflexschicht oder Infrarotreflexionsschicht auf Oberflächen, als Beschichtungsmittel auf Effektpigmenten oder als Claddinglayer auf optischen Glasfasern.

2. Verwendung gemäß Anspruch 1, **dadurch gekennzeichnet, dass** A für einen gegebenenfalls substituierten $C_2$-$C_3$-Alkylenrest und x für 0 oder 1 steht.

3. Verwendung gemäß einem der Ansprüche 1 oder 2, **dadurch gekennzeichnet, dass** das Polythiophen mit wiederkehrenden Einheiten der allgemeinen

Formel (I) Poly(3,4-ethylendioxythiophen) ist.

**4.** Verwendung gemäß einem der Ansprüche 1 bis 3, **dadurch gekennzeichnet, dass** die Funktionsschicht eine Transmission gemessen nach ASTM D 1003-00 in Verbindung mit ASTM E 308 von Y ≥ 25 % aufweist.

## Claims

**1.** Use of a transparent optical functional layer which has an index of refraction of n < 1.3 in parts of the visible spectral range and comprises at least one electrically conductive polymer comprising at least one polythiophene with repeating units of general formula (I),

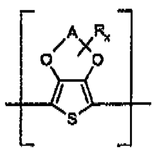

(I)

wherein

A represents an optionally substituted $C_1$-$C_5$ alkylene radical,
R represents a linear or branched, optionally substituted $C_1$-$C_{18}$ alkyl radical, an optionally substituted $C_5$-$C_{12}$ cycloalkyl radical, an optionally substituted $C_6$- $C_{14}$ aryl radical, an optionally substituted $C_7$-$C_{18}$ aralkyl radical, an optionally substituted $C_1$-$C_4$ hydroxyalkyl radical or a hydroxyl radical,
x represents an integer from 0 to 8 and

if a plurality of radicals R are bound to A, the radicals may be the same or different, as an antireflective layer or infrared reflection layer on surfaces, as a coating composition on effect pigments or as a cladding layer on optical glass fibres.

**2.** Use according to claim 1, **characterised in that** A represents an optionally substituted $C_2$-$C_3$ alkylene radical and x represents 0 or 1.

**3.** Use according to one of claims 1 or 2, **characterised in that** the polythiophene with recurring units of general formula (I) is poly(3,4-ethylenedioxythiophene).

**4.** Use according to one of claims 1 to 3, **characterised in that** the functional layer has a transmission, measured in accordance with ASTM D 1003-00 in conjunction with ASTM E 308, of Y ≥ 25 %.

## Revendications

**1.** Utilisation d'une couche fonctionnelle optique transparente qui a dans des parties de la plage visible du spectre un indice de réfraction n < 1,3 et comprend au moins un polymère conducteur électrique, qui comprend au moins un polythiophène avec des unités répétitives de la formule générale (I)

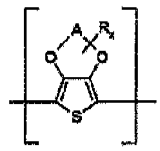

(I)

dans laquelle

A représente un radical alkylène en $C_1$ à $C_5$, substitué le cas échéant,
R représente un radical alkyle en $C_1$ à $C_{18}$ linéaire ou ramifié, substitué le cas échéant, un radical cycloalkyle en $C_5$ à $C_{12}$, substitué le cas échéant, un radical aryle en $C_6$ à $C_{14}$, substitué le cas échéant, un radical aralkyle en $C_7$ à $C_{18}$, substitué le cas échéant, un radical hydroxyalkyle en $C_1$ à $C_4$, substitué le cas échéant ou un radical hydroxyle,
x représente un nombre entier de 0 à 8 et

pour le cas où plusieurs radicaux R seraient liés à A, ceux-ci peuvent être identiques ou différents, comme couche antiréflexion ou comme couche réfléchissant les rayons infrarouges sur des surfaces, comme produit de revêtement sur des pigments à effet ou comme couches de placage sur des fibres optiques.

**2.** Utilisation selon la revendication 1, **caractérisée en ce que** A représente un radical alkylène en $C_2$ - $C_3$, substitué le cas échéant, et x représente 0 ou 1.

**3.** Utilisation selon l'une quelconque des revendications 1 ou 2, **caractérisée en ce que** le polythiophène avec des unités répétitives de la formule générale (I) est du poly(3,4-éthyléne dioxythiophène).

**4.** Utilisation selon l'une quelconque des revendications 1 à 3, **caractérisée en ce que** la couche fonctionnelle présente une transmission, mesurée d'après la norme ASTM D 1003-00 en liaison avec ASTM E 308 de Y ≥ 25 %.

**Figur 1**

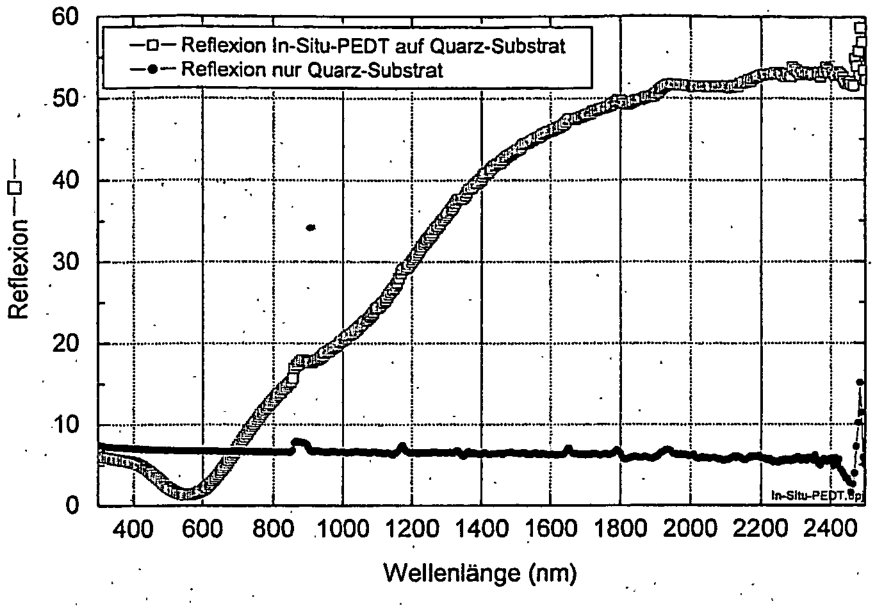


**Figur 2**

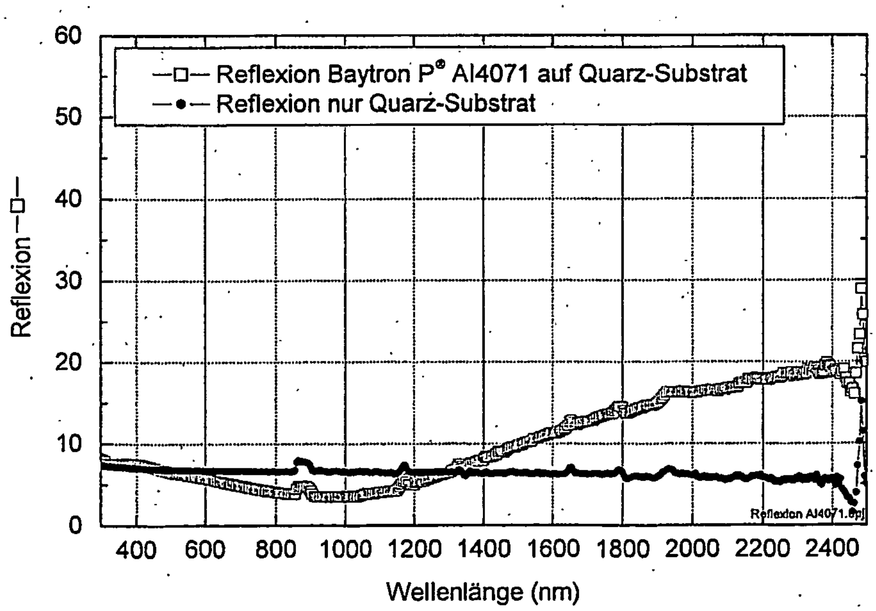

**Figur 3**

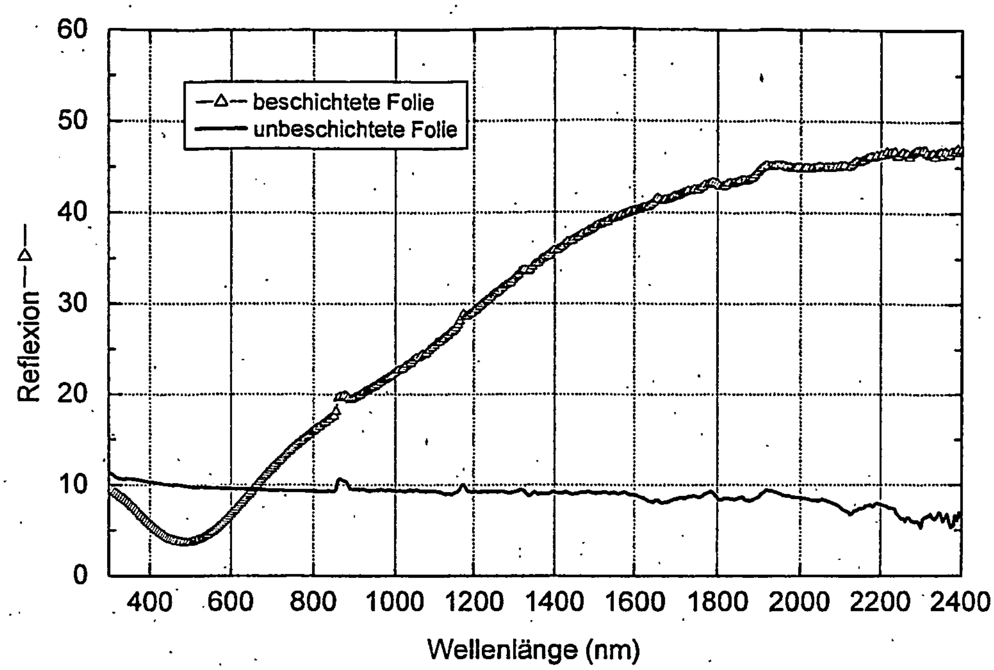


**Figur 4**

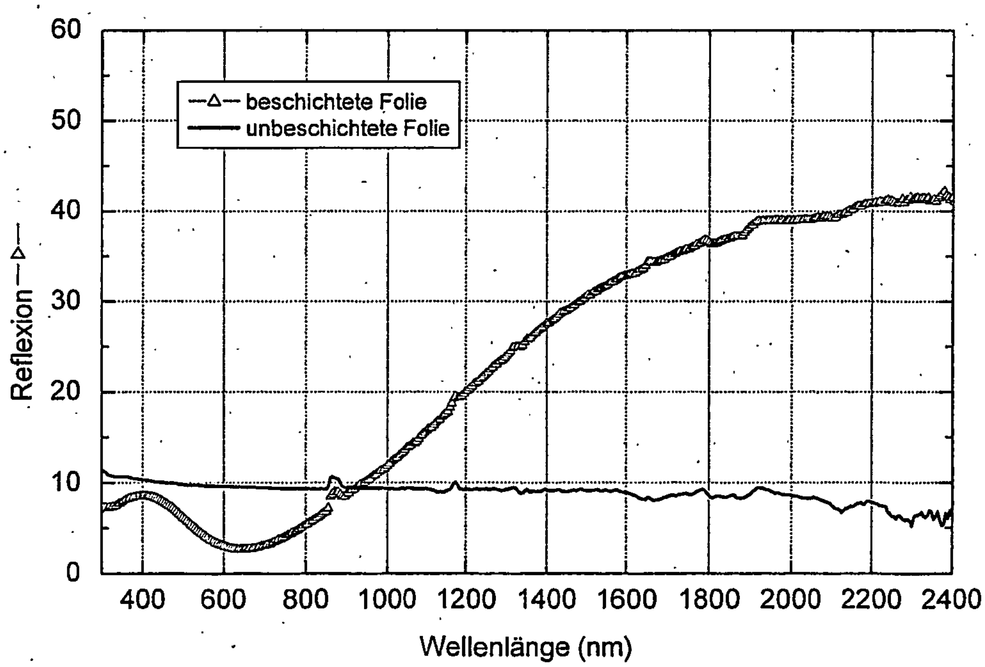

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- US 4726654 A


### In der Beschreibung aufgeführte Nicht-Patentliteratur


- **Born, Max.** Principles of Optics
- **Hohnholz et al.** *Chem. Commun.,* 2001, 2444-2445
- **L. Groenendaal ; F. Jonas ; D. Freitag ; H. Pielartzik ; J. R. Reynolds.** *Adv. Mater.,* 2000, vol. 12, 481-494
- *J. Polym. Sc. Part A Polymer Chemistry,* 1988, vol. 26, 1287
- **Groenendaal et al.** *Adv.Mat.,* 2003, vol. 15, 855
- **Bergmann Schaefer.** Optik. vol. 3, 449ff